# EUROPÄISCHE PATENTANMELDUNG

(11) **EP 1 179 448 A2**
(43) Veröffentlichungstag der Anmeldung: **13.02.2002**
(21) Anmeldenummer: 01118670.7
(22) Anmeldetag: 03.08.2001
(51) Int. Cl.: B60Q 3/04

(54) **Beleuchtungsvorrichtung für eine flächige Anzeige sowie Verfahren zur Herstellung einer Beleuchtungsvorrichtung**

(30) Priorität: 09.08.2000 DE 10038762
(71) Anmelder: ROBERT BOSCH GMBH, 70442 Stuttgart (DE)
(72) Erfinder: Knoll, Peter, 76275 Ettlingen (DE); Bombis, Christian, 52426 Juelich (DE)

(57) **Zusammenfassung**

Es wird eine Beleuchtungsvorrichtung für eine flächige Anzeigeeinheit mit einem Trägersubstrat (11) und darauf übereinander angeordneten Elektroden (12, 15, 16), zwischen welchen sich eine elektrolumineszierende Schicht (13) befindet vorgeschlagen. Dieser Beleuchtungsvorrichtung liegt die Aufgabe zugrunde, bei vergleichsweise einfachem Aufbau ausreichend hohe Leuchtdichten von unabhängig ansteuerbaren Leuchtbereichen zu erhalten. Dies wird dadurch erreicht, dass anstatt einer herkömmlichen elektrolumineszierenden Folie eine organische elektrolumineszierende Schicht zur Anwendung kommt. Des Weiteren wird ein Verfahren zur Herstellung einer Beleuchtungsvorrichtung vorgeschlagen.

## Beschreibung

Die Erfindung betrifft eine Beleuchtungsvorrichtung für eine flächige Anzeige sowie ein Verfahren zur Herstellung einer Beleuchtungsvorrichtung.

### Stand der Technik

Aus der deutschen Patentschrift DE 195 40 813 C1 ist eine Anzeigeeinheit für ein Kraftfahrzeug bekannt, das ein lichtdurchlässiges Zifferblatt, dessen Skalen, Ziffern und Zeichen durchleuchtbar sind, umfasst. Auf der dem Beobachter abgewandten Seite des Zifferblatts ist eine Lichtquelle zum Durchleuchten der Skalen, Ziffern und Zeichen angeordnet. Zwischen dem Zifferblatt und der Lichtquelle ist ein Lichtventil angeordnet, dessen Lichtdurchlässigkeit veränderbar einstellbar ist. Auf diese Weise wird es möglich, bei sonst flächiger Hinterleuchtung nur bestimmte Bereiche des Zifferblatts durch eine entsprechende Ansteuerung des Lichtventils zu beleuchten. Als Leuchtmittel werden z.B.

Leuchtstoffröhren eingesetzt. Um mit Leuchtstoffröhren eine homogene Hinterleuchtung zu realisieren und Lichtverluste weitgehend zu vermeiden, sind Lichtleiterelemente notwendig, was den Aufbau der Anzeigeeinheit aufwendig gestaltet. Der Einsatz eines Lichtventils, z.B. einer Flüssigkristallanzeige, die eine partielle Selektion der Hinterleuchtung gestattet, macht die Anzeigeeinheit noch aufwendiger und teuerer. Zudem hat das Lichtventil, insbesondere in Form einer Flüssigkristallanzeige den Nachteil, dass auch im durchgeschalteten Zustand Lichtverluste entstehen, die die Lichtausbeute der Hinterleuchtung herabsetzen.

Demgegenüber hat eine emissive Anzeige den Vorteil, dass damit unmittelbar eine bereichsweise schaltbare Hinterleuchtung ausgebildet werden kann, wodurch ein zusätzliches Lichtventil eingespart werden kann.

In der deutschen Offenlegungsschrift DE 40 23 693 A1 wird eine Anzeigeeinrichtung mit elektrolumineszierender Beleuchtung offenbart. Die Anzeigeeinrichtung besteht aus einem Träger mit wenigstens einer Elektrode, deren Kontur der Anzeige angepasst ist, einer weiteren Elektrode und einem dazwischen angeordneten, Dielektrikum mit eingelagerten, im elektrischen Wechselfeld der Elektroden lumineszierenden Pigmenten und einer transparenten, die Anzeigeseite der Einrichtung bildenden Abdeckung. Der Aufbau dieser Anzeigeeinrichtung wird besonders dadurch einfach, dass als Träger eine herkömmliche Leiterplatte mit geätzten Elektroden eingesetzt wird. Als elektrolumineszierende Schicht kommt bei einem derartigen Aufbau im Allgemeinen nur eine Elektrolumineszenzfolie in Betracht.

Es hat sich jedoch herausgestellt, dass derartige Elektrolumineszenzfolien für viele Anwendungsgebiete im Hinblick auf Anzeigeeinheiten eine unzureichende Leuchtdichte erreichen.

### Aufgabe und Vorteile der Erfindung

Der Erfindung liegt die Aufgabe zugrunde, eine Beleuchtungsvorrichtung für eine flächige Anzeigeeinheit bereitzustellen, die für die gängigen Anwendungsmöglichkeiten eine ausreichende Helligkeit bietet und bei welcher sich mit vergleichsweise geringem fertigungstechnischem Herstellungsaufwand unabhängig ansteuerbare Teilbereiche realisieren lassen.

Diese Aufgabe wird durch die Merkmale des Anspruchs 1 sowie des Anspruchs 9 gelöst. Die Erfindung geht zunächst von einer Beleuchtungsvorrichtung für eine flächige Anzeigeeinheit aus, die ein Trägersubstrat und darauf übereinander angeordnete Elektroden umfasst, zwischen welchen sich eine elektrolumineszierende Schicht befindet. Der Kerngedanke der Erfindung liegt nun darin, dass die elektrolumineszierende Schicht eine organisch elektrolumineszierende Schicht ist. Dadurch lassen sich erheblich höhere Leuchtdichten bei nach wie vor vergleichsweise einfachem Aufbau der Beleuchtungsvorrichtung erreichen. Denn das organische elektrolumineszierende Material lässt sich durch einfache fertigungstechnische Prozesse auf ein Trägersubstrat applizieren, z.B. durch Auf schleudern oder Aufgießen.

Die Selektion von nur einzelnen Bereichen der elektrolumineszierenden Schicht kann durch entsprechend strukturierte Elektroden erreicht werden.

In einer besonders vorteilhaften Ausgestaltung der Erfindung ist wenigstens eine Elektrode und die elektrolumineszierende organische Schicht für die Festlegung einer lichtemittierenden Fläche teilweise durch eine elektrisch isolierende Schicht getrennt. Dadurch wird auf elegante Art eine Festlegung der emissiven Fläche der Beleuchtungsvorrichtung erreicht. Denn an Stellen, an welchen die trennende Isolierschicht vorhanden ist, wird ein Stromfluss durch die elektrolumineszierende Schicht und damit deren Aufleuchten verhindert.

Der Aufbau wird insbesondere dann einfach, wenn sich die isolierende Schicht selbst photolithografisch strukturieren lässt. Dies ist beispielsweise bei Photolackschichten oder bei photoempfindlichen Polyimiden der Fall.

Um unabhängig selektierbare Leuchtbereiche bei gegebenenfalls weiterer Unterteilung der emissiven Bereiche zu erreichen, wird darüber hinaus vorgeschlagen, dass wenigstens auf einer Seite der elektrolumineszierenden Schicht mehrere unabhängig ansteuerbare Elektroden vorhanden sind.

Um einen leichten und flexiblen Aufbau der Beleuchtungsvorrichtung zu erhalten, wird überdies vorgeschlagen, dass das Trägersubstrat aus Kunststoff besteht.

Vorzugsweise sind die einer Anzeigeeinheit zugewandten Elektroden mehrfach geteilt und transparent.

Zur Vermeidung einer Degradation der organischen elektrolumineszierenden Schicht, insbesondere durch Luftfeuchtigkeit wird überdies vorgeschlagen, dass der auf dem Trägersubstrat angeordnete Schichtaufbau mit einer Schutzabdeckung, z.B. einem Glassubstrat, versehen ist.

Ein weiterer wesentlicher Aspekt der Erfindung liegt bei einem Verfahren zur Herstellung einer Beleuchtungsvorrichtung für eine flächige Anzeigeeinheit, bei welchem auf ein Trägersubstrat eine erste Elektrodenschicht aus elektrisch leitendem Material abgeschieden wird, danach eine Schicht aus organischem elektrolumineszierendem Material aufgebracht wird und nach der elektrolumineszierenden Schicht eine weitere Elektrodenschicht aus elektrisch leitendem Material deponiert wird, wobei entweder zwischen der ersten Elektrodenschicht und der elektrolumineszierenden Schicht und/oder zwischen der elektrolumineszierenden Schicht und der zweiten Elektrodenschicht eine elektrisch isolierende Schicht aufgebracht und strukturiert wird. Dies stellt eine einfache Möglichkeiten dar, die emissive Fläche des organischen elektrolumineszierenden Materials zu definieren.

Vorzugsweise wird bei der Herstellung eine Elektrodenschicht, vorteilhafterweise die zweite oben liegende im Allgemeinen transparente Elektrodenschicht, die z.B. aus ITO (Indium Tin Oxide) besteht, in mehrere unabhängig ansteuerbare Elektrodenbereiche aufgeteilt. Durch diese Maßnahme lassen sich Teile der Beleuchtungsvorrichtung unabhängig voneinander ein- und ausschalten oder dimmen.

Dies ist beispielsweise bei Kombinationsinstrumenten in Fahrzeugen erwünscht, um z.B. im Zifferblatt einer Geschwindigkeitsanzeige einen bestimmten Geschwindigkeitsbereich optisch herauszustellen.

### Zeichnungen

Zwei Ausführungsbeispiele der Erfindung sind in den Zeichnungen dargestellt und unter Angabe weiterer Vorteile und Einzelheiten näher erläutert. Es zeigen
- Figur 1: einen schematischen Aufbau eines Kombinationsinstruments für ein Fahrzeug in einer perspektivischen Explosionsdarstellung, in welcher die einzelnen Ebenen zur Übersichtlichkeit voneinander abgehoben sind,
- Figur 2: einen schematischen Aufbau einer Hinterleuchtungsvorrichtung mit organischer elektrolumineszierender Schicht in einer perspektivischen Explosionsdarstellung entsprechend Figur 1 und
- Figur 3a: einen schematischen Tachometer in der Draufsicht eines ausschnittsweise dargestellten Kombiinstruments und
- Figur 3b: eine erfindungsgemäße Beleuchtungsvorrichtung in einer schematischen Draufsicht für einen Tachometer gemäß Figur 3a.

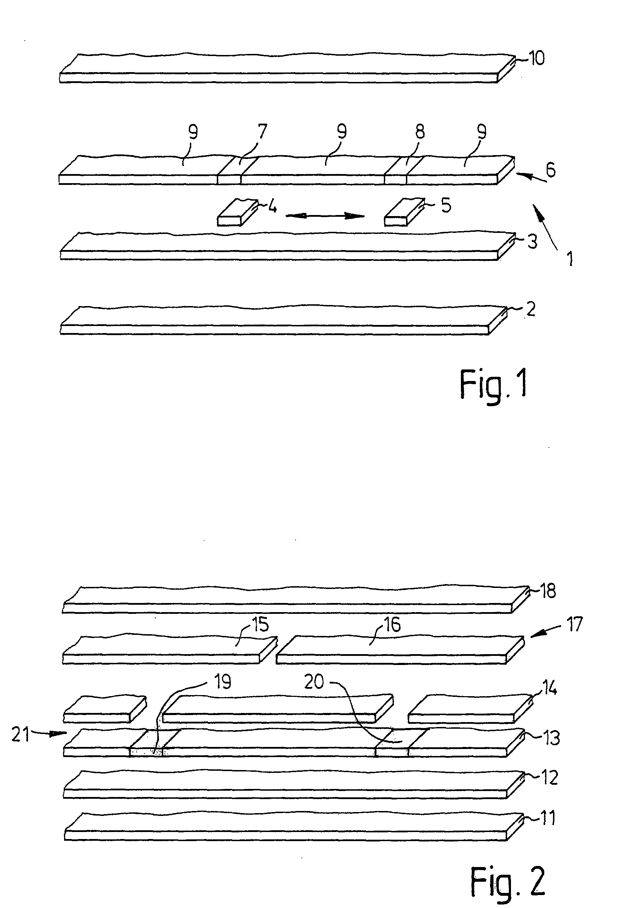

Figur 1 zeigt den schematischen Aufbau eines Kombinationsinstruments 1 in einem Fahrzeug. Das Kombinationsinstrument 1 umfasst eine Leiterplatte 2, auf der die Ansteuerelektronik der verschiedenen Komponenten des Kombinationsinstrumentes angeordnet sind. Darüber ist ein Trägersubstrat 3 mit unabhängig ansteuerbaren Bereichen 4, 5 aus organischem elektrolumineszierendem Material positioniert. Die Aufgaben des Trägersubstrats 3 könnten auch von der Leiterplatte 2 übernommen werden. D.h. das organische elektrolumnieszierende Material würde dann unmittelbar auf die Leiterplatte aufgebracht. Ebenso könnte das Trägersubstrat 3 eine Einheit mit der Leiterplatte 2 bilden. In diesem Fall könnte das Trägersubstrat 3 als dünne Folie ausgestaltet sein.

Die organischen elektrolumineszierenden Bereiche 4, 5 lassen sich durch eine auf z.B. der Leiterplatte 2 angeordnete Ansteuerelektronik ansteuern.

Über dem Trägersubstrat 3 ist ein Zifferblatt 6 angeordnet, das üblicherweise aus einer Kunststofffolie besteht und transmissive Flächen 7, 8 und absorbierende Flächen 9 besitzt. Die transmissiven Flächen 7, 8 sind beispielsweise als Ziffern, Skalenstriche oder Symbole ausgebildet. Die elektrolumineszierenden Bereiche 4, 5 sind direkt hinter den transmissiven Flächen 7, 8 positioniert und vorzugsweise mindestens gleich groß oder überlappen diese Bereiche. Durch die organischen elektrolumineszierenden Bereiche 4, 5 lassen sich vergleichsweise große Leuchtdichten erzielen, die auch den Einsatz einer über dem Zifferblatt 6 angeordneten Abdunklungsmaske 10 erlaubt. Die Abdunklungsmaske 10 wird im Allgemeinen einige Zentimeter oberhalb des Zifferblattes 6 angebracht und hat auch die Funktion einer Schutzscheibe.

Figur 2 stellt in schematischer Weise den Schichtaufbau einer organischen elektrolumineszierenden Beleuchtungsvorrichtung 21, insbesondere Hinterleuchtungsvorrichtung für eine Anzeigeeinheit, z.B. ein Kombinationsinstrument 1 dar. In Bezug auf Figur 1 kann die Hinterleuchtungsvorrichtung 21 als detaillierte Darstellung für das Trägersubstrat 3 und die elektrolumineszierenden Bereiche 4, 5 aufgefasst werden.

Die Hinterleuchtungsvorrichtung 21 besteht aus einem Glassubstrat 11, auf welchem eine durchgehende Elektrode 12 aufgebracht ist. Auf der Elektrode 12 sitzt eine elektrolumineszierende Schicht 13, die von einer strukturierten Photolackschicht 14 überdeckt wird. Darauf folgt eine in mehrere unabhängig ansteuerbare Teilelektroden 15, 16 strukturierte ITO-Schicht 17. ITO (Indium Tin Oxide oder auf deutsch Indium Zinn Oxid) ist bekanntermaßen in einer üblicherweise verwendeten Schichtdicke transparent, was dem aus der organischen elektrolumineszierenden Schicht emittierten Licht erlaubt, auf dieser Seite die Hinterleuchtungsvorrichtung 21 zu verlassen. Die Elektrode 12 hat vorteilhafterweise für eine effektive Lichtausbeute reflektierende Eigenschaften. Um den Schichtaufbau insbesondere vor Luftfeuchtigkeit zu schützen, wird günstigerweise davor eine Schutzabdeckung in Form z.B. eines weiteren Glassubstrates 18 angebracht.

Beim Schichtaufbau der Hinterleuchtungsvorrichtung 21 sind im Hinblick auf die Erfindung insbesondere zwei Aspekte nochmals herauszustellen. Durch die strukturierte Photolackschicht wird es auf einfache Weise möglich, die emissiven Bereiche, die beim Anlegen einer Spannung zwischen den Elektroden 12 und 15 bzw. 16 Licht emittieren, in exakter Weise festzulegen. Denn an den Stellen, an welchen die Photolackschicht nach der Strukturierung noch vorhanden ist, wird die darunter liegende organische elektrolumineszierende Schicht elektrisch isoliert, was das Aufleuchten der Schicht verhindert. Somit können nur die photolackfreien Bereiche 19, 20 bei Anlegen einer Spannung Licht emittieren.

Wird zwischen den Elektroden 12 und 15 eine entsprechende Ansteuerspannung angelegt, leuchtet der Bereich 19. Das Anlegen einer Spannung zwischen den Elektroden 12 und 16 führt zu einem Aufleuchten des Bereichs 20 der elektrolumineszierenden Schicht. Durch die Photolackschicht lassen sich somit in einfacher Weise emissive Strukturen vorgeben, wobei durch die unabhängig ansteuerbaren Elektrodenbereiche 15, 16 eine unabhängige Selektion der durch die Photolackstruktur definierten emissiven Flächen der elektrolumineszierenden Schicht möglich wird. D.h. die Bereiche 19, 20 lassen sich unabhängig ein- oder ausschalten oder nach Wunsch auch dimmen. Die Dimmung erfolgt üblicherweise mit einer Pulsweitenmodulation. Die organisch elektrolumineszierende Schicht 13 vereinigt den Vorteil einer Flächenlichtquelle, die ein Lichtverteilungssystem einspart mit der Möglichkeit, eine ausreichend hohe Leuchtdichte, z.B. 100 cd/m², zu erreichen , die insbesondere durch eine Elektrolumineszenzfolie nicht erreicht werden kann.

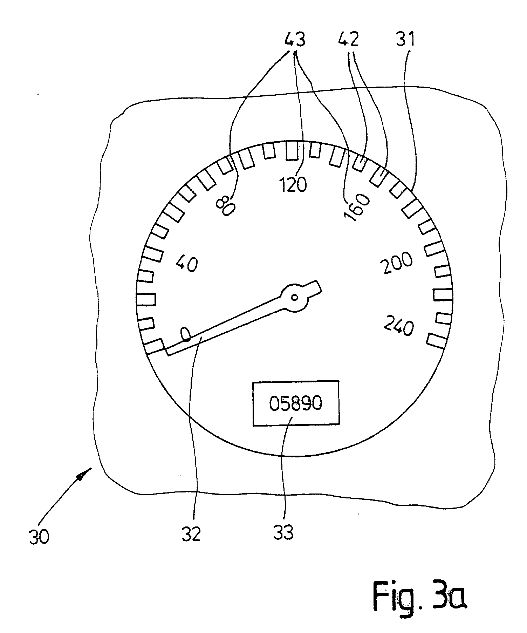

In Figur 3a ist ein Tachometer 30 mit einem Zifferblatt 31 und einer Tachonadel 32 sowie einem LCD-Display 33 für die Anzeige des Kilometerstandes abgebildet.

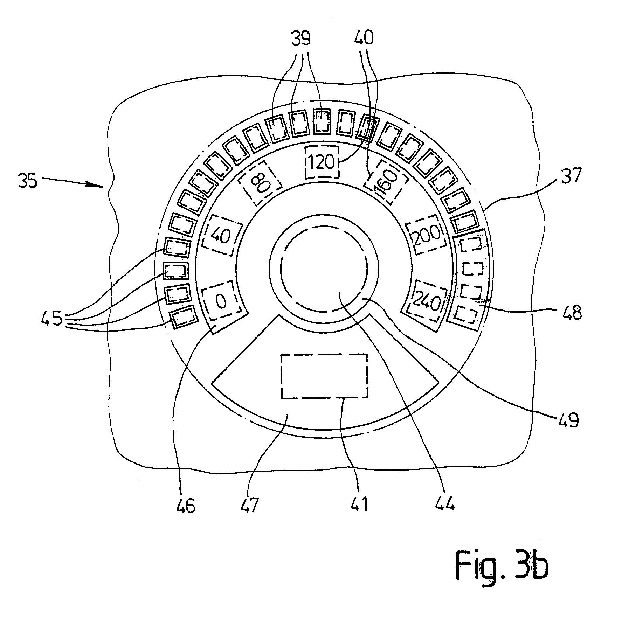

In Figur 3b ist eine erfindungsgemäße Hinterleuchtungsvorrichtung 35 für den Tachometer 30 in einer schematischen Draufsicht abgebildet.

Die Hinterleuchtungsvorrichtung 35 umfasst ein ausschnittsweise dargestelltes Trägersubstrat 36, auf dem eine nicht unterteilte durch die strichpunktierte Linie dargestellte Grundelektrode 37 aus z.B. ITO aufgebracht ist. Darauf folgt eine durchgehende organische elektrolumineszierende Schicht, die von einer Fotolackschicht 38 mit einer Vielzahl von Aussparungen 39, 40, 41 überdeckt ist.

Die Aussparungen 39 werden den Skalenstrichen 42, die Aussparungen 40 den Ziffern 43, die Aussparung 41 wird der Kilometeranzeige 33 und die Aussparung 44 dem Zentrum der Tachonadel 32 hinterlegt. Durch die Aussparungen 39, 40, 41, 44 werden die Bereiche definiert, in welchen die organische elektrolumineszierende Schicht mittels einer Gegenelektrode bei angelegter Spannung zum Aufleuchten gebracht werden kann. Die hierzu notwendigen Gegenelektroden 45, 46, 47, 48, 49 sind in durchgezogenen Strichen abgebildet.

Die Gegenelektroden 45, 46, 47, 48,49 und die übrigen Elektroden sind jeweils separat ansteuerbar.

Mittels der mit Aussparungen 39, 40, 41, 44 versehenen Fotolackschicht kann somit die exakte Struktur der Leuchtenbereiche definiert werden, die über die separat ansteuerbaren Gegenelektroden unabhängig mit unterschiedlicher Ansteuerspannung beaufschlagbar sind. Damit lassen sich im Ziffernblatt des Tachometers 30 unterschiedliche Geschwindigkeitsbereiche durch unterschiedliche Leuchtstärke der Skalenstriche 42 optisch hervorheben.

Auf diese Weise kann ein bestimmter Geschwindigkeitsbereich, in dem z.B. ein Tempomat aktiv ist, im Vergleich zum übrigen Zifferblatt heller oder dunkler beleuchtet werden, um eine optische Differenzierung zu erhalten.

## Patentansprüche

1. Beleuchtungsvorrichtung für eine flächige Anzeigeeinheit (1) mit einem Trägersubstrat (3) und darauf übereinander angeordneten Elektroden (12, 15, 16), zwischen welchen eine elektrolumineszierende Schicht (4, 5, 13) angeordnet ist, **dadurch gekennzeichnet, dass** die elektrolumineszierende Schicht eine organische elektrolumineszierende Schicht (4, 5, 13) ist.

2. Beleuchtungsvorrichtung nach Anspruch 1, **dadurch gekennzeichnet, dass** wenigstens eine Elektrode (15, 16) und die elektrolulmineszierende Schicht (13) für die Festlegung einer lichtemittierenden Fläche (19, 20) teilweise durch eine elektrisch isolierende Schicht (14) getrennt ist.

3. Beleuchtungsvorrichtung nach Anspruch 1 oder 2, **dadurch gekennzeichnet, dass** die isolierende Schicht (14) eine photolithografisch strukturierbare organische Schicht ist.

4. Beleuchtungsvorrichtung nach einem der vorhergehenden Ansprüche, **dadurch gekennzeichnet, dass** auf einer Seite der elektrolumineszierenden Schicht (13) mehrere unabhängig ansteuerbare Elektroden (15, 16) vorgesehen sind.

5. Beleuchtungsvorrichtung nach einem der vorhergehenden Ansprüche, **dadurch gekennzeichnet, dass** das Trägersubstrat (3, 12) aus Kunststoff besteht.

6. Beleuchtungsvorrichtung nach einem der vorhergehenden Ansprüche, **dadurch gekennzeichnet, dass** der auf dem Trägersubstrat angeordnete Schichtaufbau mit einer Schutzabdeckung (10, 18) versehen ist.

7. Kombinationsinstrument für ein Fahrzeug mit einer Beleuchtungseinheit gemäß einem der vorhergehenden Ansprüche.

8. Verfahren zur Herstellung einer Beleuchtungsvorrichtung für eine flächige Anzeigeeinheit (1), bei welchem auf ein Trägersubstrat (3, 11) eine erste Elektrodenschicht (12) aus elektrisch leitendem Material abgeschieden wird, danach eine Schicht (13) aus organischem elektrolumineszierendem Material aufgebracht wird, und nach der elektrolumineszierenden Schicht (13) eine weitere Elektrodenschicht (15, 16) aus elektrisch leitendem Material deponiert wird, wobei entweder zwischen der ersten Elektrodenschicht (12) und der elektrolumineszierenden Schicht oder zwischen der elektrolumineszierenden Schicht (13) und der zweiten Elektrodenschicht eine elektrisch isolierende Schicht (14) aufgebracht und strukturiert wird.

9. Verfahren nach Anspruch 8, **dadurch gekennzeichnet, dass** eine Elektrodenschicht (17) vorzugsweise die zweite Elektrodenschicht, bei einer Strukturierung in mehrere unabhängig ansteuerbare Elektrodenbereiche (15, 16) aufgeteilt wird.
